# EUROPÄISCHE PATENTSCHRIFT

(11) **EP 2 607 986 B1**
(45) Veröffentlichungstag und Bekanntmachung des Hinweises auf die Patenterteilung: **29.10.2014**
(21) Anmeldenummer: 11195189.3
(22) Anmeldetag: 22.12.2011
(51) Int. Cl.: G06F 1/18, H05K 7/14

(54) **Stromeinspeisemodul für ein modulares Computersystem**
Power feed-in module for a modular computer system
Module d'alimentation en courant pour un système informatique modulaire

(43) Veröffentlichungstag der Anmeldung: 26.06.2013
(73) Patentinhaber: Schroff GmbH, 75334 Straubenhardt (DE)
(72) Erfinder: Mann, Dietmar, 75196 Remchingen (DE); Kistner, Oliver, 75177 Pforzheim (DE)
(74) Vertreter: Durm & Partner

(56) Entgegenhaltungen:
- US-A1- 2003 062 183
- US-A1- 2010 085 687
- US-B1- 6 596 948
- KENNETH S KUNDERT: "Power Supply Noise Reduction", THE DESIGNER'S GUIDE COMMUNITY, , Bd. Version 4 4. Januar 2004 (2004-01-04), Seiten 1-12, XP002653105, Gefunden im Internet: URL:http://www.designers-guide.org/Design/ bypassing.pdf [gefunden am 2011-07-26]

## Beschreibung

Die Erfindung betrifft ein Stromeinspeisemodul für ein modulares Computersystem, mit einer Frontplatte aus Metall, in Löchern der Frontplatte isoliert befestigten Anschlussbolzen aus Metall zum Anschließen von Stromzuführungskabeln und mit zwischen den Anschlussbolzen und der Frontplatte geschalteten Filterkondensatoren.

Derartige Stromeinspeisemodule (Power Entry Module) werden vor allem für modulare Computersysteme in der Telekommunikationsindustrie, insbesondere AdvancedTCA-Systeme, eingesetzt. Diese werden typischerweise mit 48/60 V Gleichspannung betrieben. Der große Leistungsbedarf erfordert die Einspeisung von Strömen im Bereich von 200 A oder sogar darüber.

In der Gehäusewand, zum Beispiel an der Rückwand des Computersystems ist ein Ausbruch vorgesehen, der von der Frontplatte des Stromeinspeisemoduls abgedeckt wird. Bekannt sind Terminal-Blocks mit außerhalb des Gehäuses liegenden Anschraubstellen für die mit Ringösen oder "Double Lug" versehenen Stromzuführungskabel. Der Strom wird durch die Anschlussbolzen in das Innere des Stromeinspeisemoduls geleitet und dann über Kabel oder Stromschienen zu einer elektronischen Baugruppe geführt.

Um das Eindringen hochfrequenter Störungen über die Anschlussbolzen zu verhindern, sind spezielle Filterkondensatoren vorgesehen. Diese sollten sowohl nahe an den stromführenden Elementen angebracht sein als auch eine sehr kurze niederimpedante Anbindung an die metallische Frontplatte haben. Rohrkondensatoren, wie sie bei dünneren Anschlussstiften eingesetzt werden, werden bei Anschlussbolzen größerer Querschnitte in der Regel nicht verwendet, denn für größere Durchmesser sind sie teuer in der Herstellung und mechanisch empfindlich.

Im einfachsten Fall werden einzelne Anschlussbolzen in dafür vorgesehene Löcher der Frontplatte mittels Mutter und Gegenmutter eingeschraubt. An das rückwärtige Ende der Anschlussbolzen können dann Kabel oder Stromschienen angeschraubt werden. Diese Technik erfordert viel manuelle Arbeit und erfordert ausreichend freien Raum hinter der Frontplatte.

Bekannt sind auch Trägerstrukturen mit einer Anzahl von Anschlussstiften zur gemeinsamen Montage auf einer Frontplatte. US 3,781,724 beschreibt eine Trägerstruktur aus isolierendem Kunststoff, in die eine Anzahl von Anschlussstiften eingebettet ist. Außen liegende Schrauben dienen dem Anschluss externer Kabel. Die Anschlussstifte ragen durch Löcher in der Frontplatte in das Innere des Gehäuses. Konzentrisch um die Anschlussstifte angeordnete Rohrkondensatoren filtern hochfrequente Störungen aus. Zum Anschluss dicker Stromkabel und Einspeisung hoher Ströme, die entsprechend große Querschnitte der Anschlussstifte erfordern würden, ist diese Anordnung nicht geeignet.

D 1: US 2010/0085687 offenbart Stromschienen (feeder bus bars 206), die rechtwinklig abgewinkelt sind. Die Stromschienen haben Abschnitte, die parallel zu einer Ruckplatte (back plate panel 224) verlaufen. Durch den Einsatz neuer Prozessoren und erhöhte Bauteiledichte nimmt der Leistungsbedarf von modularen Computersystemen ständig zu. Die Abmessungen der genormten, modular aufgebauten Gehäuse vergrößern sich jedoch gegenüber bestehenden Systemen kaum. Da die Größe der Schraubanschlüsse sowie der Querschnitte der stromführenden Komponenten, wie insbesondere Stromzuführungskabel und Anschlussbolzen, durch die Stromstärke vorgegeben sind, wird es zunehmend schwieriger, diese erhöhten Anforderungen unter Beibehaltung der äußeren Abmessungen des gesamten Stromeinspeisemoduls zu erfüllen. Besonders schwierig ist dabei die Realisierung einer wirksamen Filterung der hochfrequenten Störungen. Als Durchführungskondensator oder Rohrkondensator ausgebildete Filterkondensatoren benötigen zu viel Platz, wenn diese direkt um dicke Anschlussbolzen herum montiert werden sollen, und wären schwierig zu montieren.

Angesichts dieser Problematik ist es Aufgabe der vorliegenden Erfindung, ein Stromeinspeisemodul für ein modulares Computersystem zu schaffen, das die Einspeisung hoher Ströme auf engstem Raum ermöglicht, dabei sehr gut HF-Störungen filtert und dessen Komponenten schnell und einfach kostensparend zusammengebaut werden können.

Bei der Lösung dieser Aufgabe wird ausgegangen von einem Stromeinspeisemodul gemäß dem Oberbegriff des Anspruchs 1. Gelöst wird die Aufgabe durch die im Kennzeichen des Anspruchs 1 angegebenen konstruktiven Merkmale.

Bei dem erfindungsgemäßen Stromeinspeisemodul sind hinter der Frontplatte Stromschienen aus Metall angeordnet, welche einen ebenen plattenförmigen Abschnitt aufweisen, der parallel zur Innenseite der Frontplatte verläuft. Auf diesem plattenförmigen Abschnitt sind mindestens zwei Anschlussbolzen befestigt; er bildet somit einen Sockel für die Anschlussbolzen. Erfindungsgemäß sind Leiterplatten aus elektrisch isolierendem Material bereichsweise zwischen den plattenförmigen Abschnitten der Stromschienen und der Innenseite der Frontplatte angeordnet, um die plattenförmigen Abschnitte gegenüber der Frontplatte zu isolieren. Die Filterkondensatoren sind auf diesen Leiterplatten angeordnet, so dass sie sich in der Nähe der Anschlussbolzen befinden und die durch die Anschlussbolzen eingedrungenen hochfrequenten Störungen wirksam arbeiten. Auf der Außenseite der Frontplatte sind Isolierplatten aus Kunststoff angeordnet, welche Ausnehmungen für die mindestens zwei Anschlussbolzen haben.

Zur Montage werden die Stromschienen mitsamt den darauf angeordneten Anschlussbolzen von der Rückseite der Frontplatte durch die in der Frontplatte vorgesehenen Löcher hindurch gesteckt. Die Befestigung geschieht auf einfachste Weise mittels klemmender Befestigungsmittel wie zum Beispiel Muttern, die auf die freien Enden der Anschlussbolzen aufgeschraubt werden. Gleichzeitig werden damit die Stromschienen an der Rückseite der Frontplatte befestigt. Die Stromschienen haben also Doppelfunktion: Zum einen ersetzen sie die bei Verwendung einzelner Anschlussbolzen üblichen Kontermuttern an der Innenseite der Frontplatte, und zum anderen dienen sie der Weiterleitung und Verteilung des über die Anschlussbolzen eingeleiteten Stroms. Da die Stromschienen jeweils mindestens zwei Anschlussbolzen tragen, können sich die durch die Löcher der Frontplatte gesteckten Anschlussbolzen nicht gegenüber der Frontplatte verdrehen, was die Montage weiter vereinfacht. Vor der Befestigung der Stromschienen mitsamt den Anschlussbolzen an der Frontplatte sind noch die Isolierplatten auf die freien Enden der Anschlussbolzen aufzuschieben. Gegenüber einzelnen Isolierscheiben haben die Isolierplatten den Vorteil, dass sie die Anschlussstellen für die Stromzuführungskabel großflächig gegenüber der Frontplatte isolieren und schneller montiert sind.

Vorzugsweise tragen die plattenförmigen Abschnitte der Stromschienen jeweils vier Anschlussbolzen, welche parallel zueinander und senkrecht zur Frontplatte ausgerichtet sind. Es ergibt sich dadurch ein vorzugsweise rechteckiger Grundriss der ebenen plattenförmigen Abschnitte der Stromschienen. Auch die korrespondierenden Isolierplatten sind dann vorzugsweise rechteckig auszuführen, mit vier Ausnehmungen für die vier Anschlussbolzen der gegenüberliegenden Stromschiene. Die Stromeinspeisung erfolgt dann über bis zu acht Stromzuführungskabel, die an die insgesamt acht Anschlussbolzen angeschlossen sind, je vier für ein Gleichspannungs-Potential. Hinter der Frontplatte fließen die Ströme dann durch zwei Stromschienen, jeweils eine pro Potential, weiter auf die elektronischen Schaltungen.

Eine mechanisch feste, insbesondere verdrehfeste Verbindung zwischen Anschlussbolzen und zugehöriger Stromschiene bei gleichzeitig niederohmigem elektrischen Kontakt wird erreicht, wenn die Anschlussbolzen in Löcher der Stromschienen eingepresst sind. Diese Befestigungsart hat zudem den Vorteil, dass die Anschlussbolzen bündig mit der Oberfläche der Stromschienen enden können, so dass zur Befestigung der Anschlussbolzen kein zusätzlicher Raum benötigt wird. Der hinter der Frontplatte benötigte Platz wird durch die Dicke der Stromschienen und der zwischengelegten Leiterplatten definiert.

Es ist zweckmäßig, die Anschlussbolzen als Gewindebolzen auszuführen. Die Befestigung an der Frontplatte geschieht dann durch einfaches Aufschrauben von Muttern auf die freien Enden der Anschlussbolzen. Da die gegenüberliegenden Enden der Anschlussbolzen mit den Stromschienen fest verbunden sind, entfallen die sonst üblichen Kontermuttern auf der Rückseite der Frontplatte. Eine Verdrehung der Anschlussbolzen in den Löchern der Frontplatte ist ausgeschlossen, da erfindungsgemäß jeweils mindestens zwei Anschlussbolzen mit einer Stromschiene fest verbunden sind.

Ein wesentliches Merkmal der Erfindung ist, dass die hinter der Frontplatte angeordneten Stromschienen jeweils mindestens einen ebenen Abschnitt haben, der plattenförmig ausgebildet ist und sich parallel zur Innenseite der Frontplatte erstreckt. Diese Abschnitte nehmen die Enden der Anschlussbolzen auf. In vorteilhafter Weiterbildung der Erfindung weisen die Stromschienen darüber hinaus wenigstens einen abgewinkelten Abschnitt auf, der sich an den plattenförmigen Abschnitt anschließt und sich senkrecht zur Frontplatte erstreckt, also in den Raum hinter der Frontplatte hinein. Gegebenenfalls können sich weitere abgewinkelte Abschnitte anschließen, so dass die Stromschiene mehrfach abgewinkelt ist und sich ein letzter Abschnitt zum Beispiel parallel zu einer Platine, die senkrecht zur Frontplatte steht, erstreckt, oder in einem Abschnitt endet, der sich wieder parallel zur Frontplatte, aber in gewissem Abstand zu dieser erstreckt. Da der Raum hinter der Frontplatte nicht durch hineinragende Anschlussbolzen eingeschränkt ist, lässt sich die Geometrie der Stromschienen weitgehend frei gestalten. Im Hinblick auf die beschränkten Gehäuseabmessungen und die immer größerer Packungsdichte der Elektronikbaugruppen stellt dies ein erheblicher Vorteil dar.

Die zwischen Stromschienen und Isolierplatten angeordneten Leiterplatten haben neben ihrer Aufgabe, die Stromschienen von der metallenen Frontplatte zu isolieren, vor allem die Aufgabe, die Filterkondensatoren aufzunehmen und elektrisch mit der Frontplatte und den Anschlussbolzen zu verbinden. Vorzugsweise sind die Filterkondensatoren als diskrete Bauteile in SMD-Technik (Surface Mounted Device) ausgebildet. Diese Bauform zeichnet sich durch kleine flache Gehäuse aus, die auf der Oberseite der Frontplatte nur wenig Platz beanspruchen. Die SMD-Kondensatoren können mit ihrer einen Elektrode über Leiterbahnen der Leiterplatte mit den Rändern der Stromschienen verbunden sein, während die Gegenelektroden über Durchkontaktierungen mit der Innenseite der Frontplatte verbunden sind. Bevorzugt weist die Leiterplatte an ihrer Rückseite eine durchgängige leitfähige Schicht auf, die einen großflächigen und damit sehr niederimpedanten Kontakt zur Innenseite der Frontplatte herstellt. Wichtig dabei ist, dass die Filterkondensatoren so nah wie möglich an den Anschlussbolzen platziert werden, so dass sie über sehr kurze und niederinduktive Verbindungen elektrisch mit der Frontplatte (Masse) und den Anschlussbolzen verbunden sind. Durch diese Anordnung werden durch die Anschlussbolzen eingeleitete Störsignale direkt auf kürzestem Weg an die Frontplatte des geschirmten Gehäuses abgeleitet, was gerade für hohe Störfrequenzen sehr wichtig ist.

In Weiterbildung der Erfindung weisen die auf der Außenseite der Frontplatte angeordneten Isolierplatten aus Kunststoff angeformte Kragen um die Löcher für die Anschlussbolzen auf. Diese Kragen greifen in die Löcher der Frontplatte ein und umgeben die Anschlussbolzen konzentrisch. Damit ergibt sich eine optimale Isolierung der Anschlussbolzen gegenüber der Frontplatte und gleichzeitig ein spielfreier Sitz in den Löchern.

Ein Ausführungsbeispiel der Erfindung wird nachstehend anhand der beigefügten Zeichnungen beschrieben. Es zeigen:
- Figur 1a: ein Stromeinspeisemodul, von vorne;
- Figur 1b: das Stromeinspeisemodul von Fig. 1a, von der Seite;
- Figur 2: einen Horizontalschnitt entlang der Linie A-A in Fig. 1a;
- Figur 3: einen Vertikalschnitt entlang der Linie B-B in Fig. 1 b.

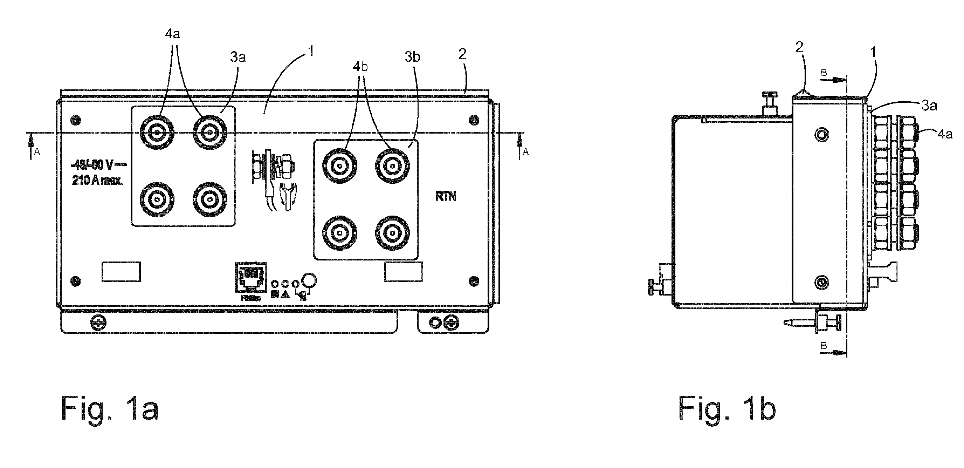

Das in den Figuren 1a und 1b abgebildete Stromeinspeisemodul dient der Versorgung eines modularen Computersystems für die Telekommunikationsindustrie nach dem AdvancedTCA-Standard mit Gleichspannung von -48/-60 V nominal. Das Gehäuse des Moduls umfasst eine Frontplatte 1 aus Stahlblech. Die Frontplatte 1 ist U-förmig nach hinten abgekantet. Das ganze Modul wird in einen Ausbruch an der Rückwand des (hier nicht dargestellten) Computersystems eingeschoben. Metallisch leitende Dichtungsstreifen 2 an den Rändern dienen zur Abdichtung gegen hochfrequente Störstrahlung.

In Löchern, die durch zwei rechteckige Isolierplatten 3a, 3b aus Kunststoff abgedeckt sind, sitzen insgesamt acht Gewindebolzen 4a, 4b, die in zwei Gruppen zu jeweils vier angeordnet und zum Anschrauben von (nicht dargestellten) Stromzuführungskabeln vorgesehen sind. Die erste Gruppe von Gewindebolzen 4a liegt auf dem negativen Gleichspannungs-Potential, die zweite Gruppe von Gewindebolzen 4b auf dem Bezugspotential RTN. Die Befestigung der Stromzuführungskabel mittels Öse, Federring und Mutter wird durch das zwischen den Isolierplatten 3a und 3b aufgedruckte Symbolbild erläutert.

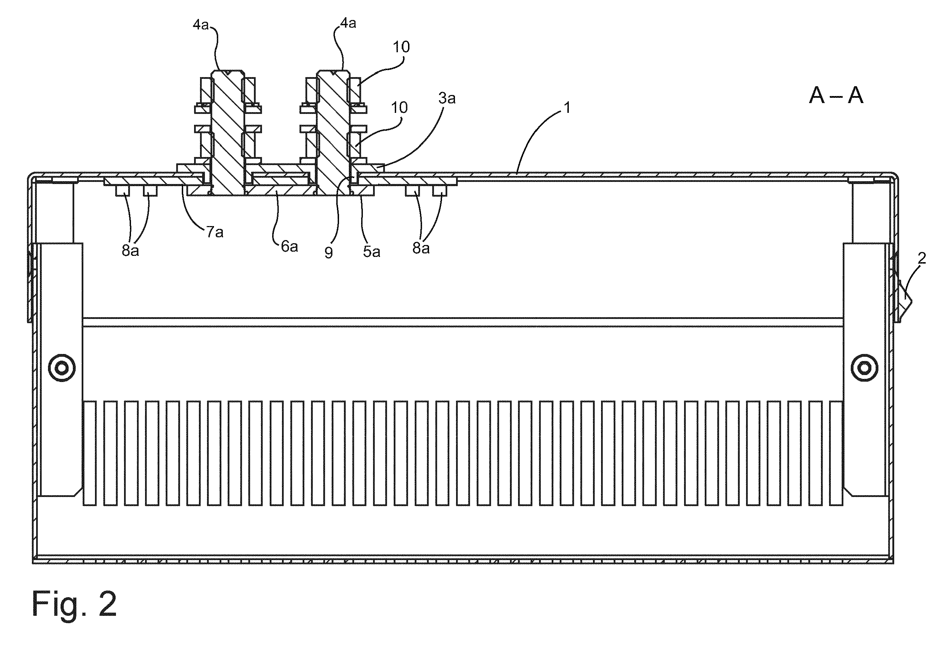

Entsprechend der Lage der Schnittlinie A-A ist in Figur 2 nur die linke Gruppe von Gewindebolzen 4a und die zugehörige Isolierplatte 3a zu sehen. Eine erste Stromschiene 5a aus dickem Kupferblech ist mit etwas Abstand hinter der Frontplatte 1 angeordnet und umfasst einen ebenen plattenförmigen Abschnitt 6a, der parallel zur Innenseite der Frontplatte 1 verläuft. Die Enden der Gewindebolzen 4a sind in Löcher der Stromschiene 5a eingepresst und damit mit dieser elektrisch und mechanisch fest verbunden. Alle vier Gewindebolzen 4a dieser Gruppe verlaufen parallel zueinander und senkrecht zur Frontplatte 1 (vgl. Fig. 1a, Fig. 1b).

Zwischen dem plattenförmigen Abschnitt 6a der Stromschiene 5a und der Innenseite der Frontplatte 1 erstreckt sich eine Leiterplatte 7a aus elektrisch isolierendem Material. An den Abschnitt, der von der Stromschiene 5a abgedeckt wird, schließen sich rechts und links freiliegende Abschnitte an. Auf diesen Abschnitten der Leiterplatte 7a sind Filterkondensatoren 8a, die als SMD-Bauteile ausgebildet sind, angeordnet. Die Filterkondensatoren 8a sind elektrisch zwischen den Gewindebolzen 4a und der auf Masse-Potential liegenden Frontplatte 1 geschaltet. Hierzu sind die Filterkondensatoren 8a mit ihrer einen Elektrode über Leiterbahnen der Leiterplatte 7a mit den Ränder der Stromschiene 5a verbunden, während die Gegenelektroden über Durchkontaktierungen der Leiterplatte 7a mit der Innenseite der Frontplatte 1 in Kontakt stehen. Der Abstand zwischen Filterkondensatoren 8a und den nächstgelegenen Gewindebolzen 4a ist so klein, dass über die Gewindebolzen 4a eingeleitete Störsignale auf kürzestem Wege zur Frontplatte abgeleitet werden.

Auf der Außenseite der Frontplatte 1 ist die Isolierplatte 3a angeordnet. Diese hat Durchführungen für die Gewindebolzen 4a und angeformte Kragen 9, welche in die Löcher der Frontplatte 1 eingreifen und damit die Durchführungen für die Gewindebolzen 4a bilden. Befestigungsmuttern 10 sind auf die Gewindebolzen 4a aufgeschraubt und ziehen diese gegen die Innenseite der Frontplatte 1. Dabei wirkt die fest verbundene Stromschiene 5a als Gegenhalt und gleichzeitig Verdrehsicherung, ersetzt also die sonst erforderlichen Gegenmuttern.

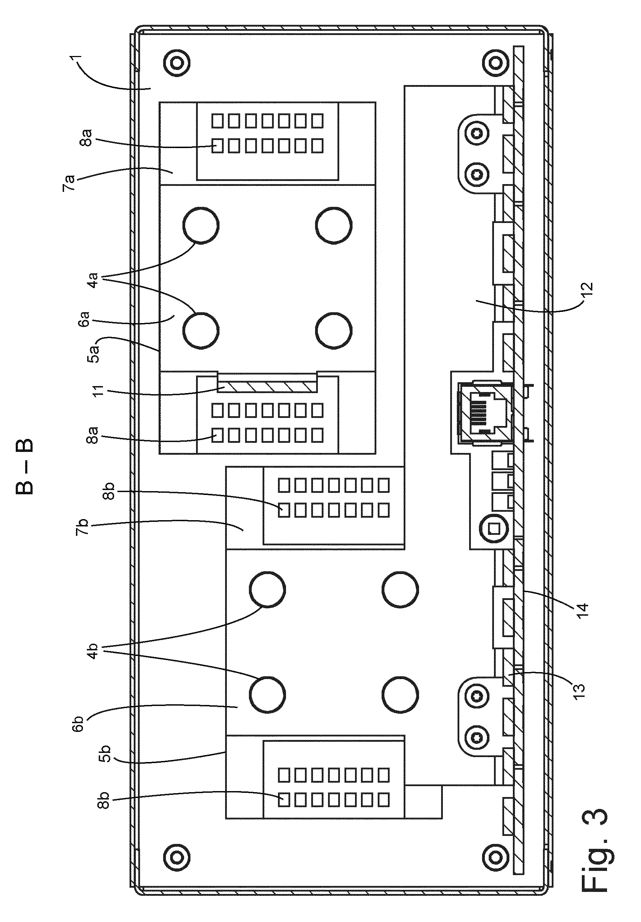

In Figur 3 ist auch die zweite Gruppe von vier Gewindebolzen 4b zu sehen. Diese sind mit einer zweiten Stromschiene 5b verbunden. Auch diese Stromschiene 5b hat einen ebenen plattenförmigen Abschnitt 6b, der sich parallel zur Innenseite der Frontplatte 1 erstreckt und quasi als Sockel die Enden der Gewindebolzen 4b aufnimmt. Eine zweite Leiterplatte 7b isoliert die Stromschiene 5b gegenüber der Frontplatte 1 und bietet gleichzeitig Platz für den Gewindebolzen 4b zugeordnete Filterkondensatoren 8b auf Abschnitten, die nicht von dem plattenförmigen Abschnitt 6b der Stromschiene 5b überdeckt sind. Die Filterkondensatoren 8b sind über Leiterbahnen bzw. Durchkontaktierungen zwischen Frontplatte 1 und Gewindebolzen 4b geschaltet.

Die plattenförmigen Abschnitte 6a, 6b der Stromschienen 5a, 5b liegen in einer gemeinsamen Ebene wenige Millimeter hinter der Frontplatte 1. Die erste (in Fig. 3 rechte) Stromschiene 5a weist anschließend an den plattenförmigen Abschnitt 6a einen abgewinkelten Abschnitt 11 auf, der sich senkrecht zur Frontplatte 1, also in den freien Raum dahinter erstreckt.

Die zweite (linke) Stromschiene 5b umfasst neben dem plattenförmigen Abschnitt 6b, der als Sockel bzw. Halterung für die Gewindebolzen 4b dient, weitere ebene Abschnitte 12 in derselben Ebene und zusätzlich auch einen abgewinkelten Abschnitt 13, der sich senkrecht zu Ebene der Frontplatte 1 erstreckt. Dieser abgewinkelte Abschnitt 13 der Stromschiene 5b ist mechanisch und elektrisch mit einer Platine 14 verbunden, welche Teil der elektronischen Schaltung des Stromeinspeisemoduls ist. Auf diese Weise werden die hohen Ströme, die durch die Gewindebolzen 4b eingespeist werden, auf direktem Weg und durch einen Stromleiter großen Querschnittes äußerst verlustarm auf die Platine 14 weitergeleitet.

Der abgewinkelte Abschnitt 11 der Stromschiene 5a ist in ähnlicher Weise über weitere (nicht dargestellte) Leiterabschnitte mit der Platine 14 verbunden.

### Bezugszeichen

- 1: Frontplatte
- 2: Dichtungsstreifen
- 3a, 3b: Isolierplatten
- 4a, 4b: Gewindebolzen
- 5a, 5b: Stromschienen
- 6a, 6b: plattenförmige Abschnitte (von 5a, 5b)
- 7a, 7b: Leiterplatten
- 8a, 8b: Filterkondensatoren
- 9: Kragen (an 3a, 3b)
- 10: Befestigungsmutter
- 11: abgewinkelter Abschnitt (von 5a)
- 12: ebener Abschnitt (von 5b)
- 13: abgewinkelter Abschnitt (von 5b)
- 14: Platine

## Patentansprüche

1. Stromeinspeisemodul für ein modulares Computersystems mit einer Frontplatte aus Metall;
in Löchern der Frontplatte isoliert befestigte Anschlussbolzen aus Metall zum Anschließen von Stromzuführungskabeln;
zwischen den Anschlussbolzen und der Frontplatte geschalteten Filterkondensatoren;
**gekennzeichnet durch**
hinter der Frontplatte (1) angeordnete Stromschienen (5a, 5b) aus Metall mit ebenen plattenförmigen Abschnitten (6a, 6b), die parallel zur Innenseite der Frontplatte (1) verlaufen und mit jeweils mindestens zwei Anschlussbolzen (4a, 4b) fest verbunden sind, so dass die plattenförmigen Abschnitte (6a, 6b) Sockel für die Anschlussbolzen (4a, 4b) bilden;
Leiterplatten (7a, 7b) aus elektrisch isolierendem Material, welche bereichsweise zwischen den plattenförmigen Abschnitten (6a, 6b) der Stromschienen (5a, 5b) und der Innenseite der Frontplatte (1) liegen und auf welchen die Filterkondensatoren (8a, 8b) angeordnet sind;
auf der Außenseite der Frontplatte (1) angeordnete Isolierplatten (3a, 3b) aus Kunststoff mit Durchführungen für die mindestens zwei Anschlussbolzen (4a, 4b).

2. Stromeinspeisemodul nach Anspruch 1, **dadurch gekennzeichnet, dass** die plattenförmigen Abschnitte (6a, 6b) der Stromschienen (5a, 5b) jeweils vier parallele Anschlussbolzen (4a, 4b) tragen, welche senkrecht zur Frontplatte (1) ausgerichtet sind.

3. Stromeinspeisemodul nach Anspruch 1 oder 2, **dadurch gekennzeichnet, dass** die Anschlussbolzen (4a, 4b) in Löcher der Stromschienen (5a, 5b) eingepresst sind.

4. Stromeinspeisemodul nach einem der Ansprüche 1 bis 3, **dadurch gekennzeichnet, dass** die Anschlussbolzen (4a, 4b) als Gewindebolzen ausgeführt sind.

5. Stromeinspeisemodul nach einem der Ansprüche 1 bis 4, **dadurch gekennzeichnet, dass** zumindest eine Stromschiene (5a, 5b) anschließend an den plattenförmigen Abschnitt (6a, 6b) wenigstens einen abgewinkelten Abschnitt (11, 13) aufweist, der sich senkrecht zur Frontplatte (1) erstreckt.

6. Stromeinspeisemodul nach einem der Ansprüche 1 bis 5, **dadurch gekennzeichnet, dass** die Filterkondensatoren (8a, 8b) als diskrete SMD-Kondensatoren ausgebildet sind, deren eine Elektrode über Leiterbahnen der Leiterplatte (7a, 7b) mit den Rändern der Stromschienen (5a, 5b) verbunden sind und deren Gegenelektroden über Durchkontaktierungen mit der Innenseite der Frontplatte (1) in Kontakt stehen.

7. Stromeinspeisemodul nach einem der Ansprüche 1 bis 6, **dadurch gekennzeichnet, dass** die Isolierplatten (3a, 3b) angeformte Kragen (9) aufweisen, welche in die Löcher der Frontplatte (1) eingreifen und die Anschlussbolzen (4a, 4b) umgeben.

## Claims

1. A power feed-in module for a modular computer system with a metallic front plate;
connecting bolts of metal fastened in an insulated manner in holes in the front plate for the connection of power supply cables;
filter capacitors connected between the connecting bolts and the front plate;
**characterised by**
metallic power rails (5a, 5b) arranged behind the front plate (1) with flat, plate-shaped sections (6a, 6b), which extend parallel to the inner surface of the front plate (1) and are rigidly connected to at least two respective connecting bolts (4a, 4b) so that the plate-shaped sections (6a, 6b) define sockets for the connecting bolts (4a, 4b);
printed circuit boards (7a, 7b) of electrically insulating material, regions of which are situated between the plate-shaped sections (6a, 6b) of the power rails (5a, 5b) and the inner surface of the front plate (1) and on which the filter capacitors (8a, 8b) are arranged;
insulating plates (3a, 3b) of plastic material arranged on the outer surface of the front plate (1) with passages for the at least two connecting bolts (4a, 4b).

2. A power feed-in module as claimed in Claim 1, **characterised in that** the plate-shaped sections (6a, 6b) of the power rails (5a, 5b) each carry four parallel connecting bolts (4a, 4b), which are aligned perpendicularly to the front plate (1).

3. A power feed-in module as claimed in Claim 1 or 2, **characterised in that** the connecting bolts (4a, 4b) are pressed into holes in the power rails (5a, 5b).

4. A power feed-in module as claimed in one of Claims 1 to 3, **characterised in that** the connecting bolts (4a, 4b) are constructed in the form of threaded bolts.

5. A power feed-in module as claimed in one of Claims 1 to 4, **characterised in that** adjacent to the plate-shaped sections (6a, 6b) at least one power rail (5a, 5b) has at least one angled section (11, 13), which extends perpendicular to the front plate (1).

6. A power feed-in module as claimed in one of Claims 1 to 5, **characterised in that** the filter capacitors (8a, 8b) are constructed in the form of discrete SMD capacitors, one electrode of which is connected via conductive tracks on the printed circuit boards (7a, 7b) to the edges of the power rails (5a, 5b) and the backing electrodes of which are in contact via through connectors with the inner side of the front plate (1).

7. A power feed-in module as claimed in one of Claims 1 to 6, **characterised in that** the insulating plates (3a, 3b) have collars (9) formed on them, which engage in the holes in the front plate (1) and surround the connecting bolts (4a, 4b).

## Revendications

1. Module d'alimentation en courant pour un système informatique modulaire comprenant
une plaque frontale en métal ;
des boulons de raccordement en métal, fixés de manière isolée dans des trous de la plaque frontale, destinés à raccorder des câbles d'alimentation en courant ;
des condensateurs de filtrage montés entre les boulons de raccordement et la plaque frontale ;
**caractérisé par**
des rails conducteurs (5a, 5b) en métal, disposés derrière la plaque frontale (1), comprenant des section planes (6a, 6b) en forme de plaque, qui s'étendent parallèlement au côté intérieur de la plaque frontale (1) et sont reliés de manière fixe à respectivement au moins deux boulons de raccordement (4a, 4b), de manière à ce que les sections (6a, 6b) en forme de plaque forment des socles pour les boulons de raccordement (4a, 4b) ;
des plaquettes à circuit imprimé (7a, 7b) en matériau électro-isolant, lesquelles sont situées par endroits entre les sections (6a, 6b) en forme de plaque des rails conducteurs (5a, 5b) et le côté intérieur de la plaque frontale (1) et sur lesquelles sont disposés les condensateurs de filtrage (8a, 8b), sur le côté extérieur de la plaque frontale (1) sont disposées des plaques isolantes (3a, 3b) en matière plastique avec traversées pour au moins deux boulons de raccordement (4a, 4b).

2. Module d'alimentation en courant selon la revendication 1, **caractérisé en ce que** les sections (6a, 6b) en forme de plaque des rails conducteurs (5a, 5b) portent respectivement quatre boulons de raccordement parallèles (4a, 4b), lesquels sont orientés verticalement par rapport à la plaque frontale (1).

3. Module d'alimentation en courant selon la revendication 1 ou 2, **caractérisé en ce que** les boulons de raccordement (4a, 4b) sont enfoncés dans des trous des rails conducteurs (5a, 5b).

4. Module d'alimentation en courant selon l'une quelconque des revendications 1 à 3, **caractérisé en ce que** les boulons de raccordement (4a, 4b) sont réalisés comme boulons filetés.

5. Module d'alimentation en courant selon l'une quelconque des revendications 1 à 4, **caractérisé en ce qu'**au moins un rail conducteur (5a, 5b), présente au moins une section repliée (11, 13) de manière adjacente à la section (6a, 6b) en forme de plaque, laquelle section repliée s'étend perpendiculairement à la plaque frontale (1).

6. Module d'alimentation en courant selon l'une quelconque des revendications 1 à 5, **caractérisé en ce que** les condensateurs de filtrage (8a, 8b) sont réalisés comme condensateurs SMD discrets, une électrode desquels étant reliée avec les bords des rails conducteurs (5a, 5b) par l'intermédiaire de circuits conducteurs de la plaquette à circuit imprimé (7a, 7b), et dont les contre-électrodes sont en contact avec le côté intérieur de la plaque frontale (1) par l'intermédiaire de connexions entières.

7. Module d'alimentation en courant selon l'une quelconque des revendications 1 à 6, **caractérisé en ce que** les plaques d'isolation (3a, 3b) présentent des collets formés (9) qui ont prise dans les trous de la plaque frontale (1) et entourent les boulons de raccordement (4a, 4b).
